# FASCICULE DE BREVET EUROPEEN

(11) **EP 2 741 323 B1**
(45) Date de publication et mention de la délivrance du brevet: **03.02.2016**
(21) Numéro de dépôt: 13195971.0
(22) Date de dépôt: 06.12.2013
(51) Int. Cl.: H01L 23/427, H05K 7/20, H05K 13/04, H01L 23/31

(54) **Composant électronique et procédé de fabrication de ce composant électronique**
Elektronisches Bauteil und Herstellungsverfahren dieses elektronischen Bauteils
Electronic component and method for manufacturing said electronic component

(30) Priorité: 07.12.2012 FR 1261795
(43) Date de publication de la demande: 11.06.2014
(73) Titulaire: Commissariat à l'Énergie Atomique et aux Énergies Alternatives, 75015 Paris (FR)
(72) Inventeur: Ben Jamaa, Haykel, 38000 GRENOBLE (FR); Baillin, Xavier, 38920 CROLLES (FR); Ollier, Emmanuel, 38000 GRENOBLE (FR); Soupremanien, Ulrich, 38100 GRENOBLE (FR)
(74) Mandataire: GIE Innovation Competence Group

(56) Documents cités:
- EP-A2- 1 385 206
- EP-A2- 1 703 557
- US-A- 6 146 921
- US-A1- 2007 290 310
- US-A1- 2012 133 039
- US-B1- 6 317 321
- US-B1- 6 534 859

## Description

L'invention concerne un composant électronique ainsi qu'un procédé de fabrication de ce composant électronique.

L'évolution des systèmes microélectroniques pendant les dernières décennies a été dans le sens de l'augmentation de la fonctionnalité grâce à la réduction des dimensions lithographiques, en suivant la loi dite de « Moore ». Depuis moins d'une décennie, des fonctionnalités peuvent être ajoutées au système microélectronique en utilisant des possibilités offertes par l'intégration suivant la dimension verticale, dite intégration 3D. Cette augmentation de la densité d'intégration dans les trois dimensions disponibles du composant électronique a eu comme conséquence directe l'augmentation de la densité de puissance, engendrant une augmentation de la température des jonctions des transistors, et en général de la température d'opération de la puce.

Ainsi, des composants électroniques connus comportent :
- un substrat qui s'étend essentiellement dans un plan appelé « plan du substrat », ce substrat étant équipé de connexions électriques pour raccorder le composant électronique à un circuit électronique, ce substrat présentant une face supérieure,
- au moins une puce électronique disposée sur la face supérieure du substrat et/ou à l'intérieur le substrat et électriquement raccordée aux connexions électriques par l'intermédiaire de ce substrat,
- un boîtier principalement formé par une couche épaisse (8) en matériau électriquement isolant recouvrant la face supérieure du substrat et/ou au moins une partie de la puce électronique.

Le circuit électronique est typiquement un circuit imprimé ou un circuit intégré.

Pour refroidir la puce électronique d'un tel composant électronique, il a déjà été proposé de réaliser des réseaux de canaux à l'intérieur desquels circule un liquide caloporteur. Cette solution est encombrante et consomme de l'énergie pour faire circuler le liquide caloporteur à l'intérieur des canaux.

Pour remédier à cet inconvénient, il a été proposé des solutions passives mettant en oeuvre des matériaux absorbeurs de chaleur tels que des matériaux à changement de phase ou PCM (« Phase Change Material »). De telles solutions sont divulguées, par exemple, dans la demande FR2985603, déposée le 10 janvier 2012, ou dans la demande US 6 097 602.

De l'état de la technique est également connu de :
- US2007/290310A1,
- EP1 385 206 A2,
- US 6 146 921 A,
- EP 1 703 557A2,
- US2012/133039A1,
- US6 317 321B1 et US6534859 B1.

Ces solutions passives permettent d'absorber la chaleur lorsque la température de la puce électronique augmente et de restituer la chaleur emmagasinée par l'absorbeur de chaleur quand la température de la puce électronique décroît. Les solutions passives permettent donc surtout de lisser les variations de température de la puce électronique mais pas nécessairement de la refroidir. Ces solutions passives sont bien adaptées à des composants électroniques destinés à être intégrés dans des appareils, par exemple mobiles, dans lesquels l'augmentation de la température de la puce électronique est uniquement transitoire.

Toutefois, l'intégration d'un matériau absorbeur de chaleur à l'intérieur d'un composant électronique est complexe surtout qu'il est souvent souhaité que la quantité de matériaux absorbeurs de chaleur intégrés à l'intérieur du composant électronique soit importante. De plus, il est souhaitable d'améliorer l'efficacité du lissage de la température.

L'invention vise à remédier à cet inconvénient. Elle a donc pour objet un composant électronique conforme à la revendication 1.

Le fait de placer la cavité à l'intérieur de la couche épaisse simplifie la réalisation du composant électronique car il n'est plus nécessaire d'ajouter à l'intérieur de ce composant électronique une couche supplémentaire, typiquement en silicium, et à l'intérieur de laquelle est ménagée la cavité contenant le matériau absorbeur de chaleur.

En effet, quel que soit le composant électronique, la couche épaisse existe déjà pour le protéger des agressions de l'environnement extérieur. Cette couche épaisse remplit alors ici une fonction supplémentaire, à savoir une fonction d'accueil de la cavité remplie du matériau absorbeur de chaleur pour lisser les variations de température de la puce électronique.

De plus, étant donné que la couche épaisse présente généralement une épaisseur importante, c'est-à-dire supérieure à 50 ou 100 µm, il est possible de réaliser une ou plusieurs cavités à l'intérieur de cette couche épaisse pour contenir un volume important de matériaux absorbeurs de chaleur. Un volume important de matériaux absorbeurs de chaleur accroît l'efficacité du lissage de la température de la puce électronique.

En fin, la présence d'une couche d'interface thermique permet d'accélérer la diffusion de la chaleur vers le matériau absorbeur de chaleur, ce qui accroît l'efficacité du lissage de la température de la puce électronique.

L'invention permet une plus grande flexibilité sur le volume et le type de matériau absorbeur utilisés et sur la taille, la géométrie et l'emplacement de la ou des cavités ce qui permet d'optimiser plus facilement l'évacuation de la chaleur et ainsi d'écrêter plus efficacement les pics de températures pouvant être produit par la puce électronique.

Les modes de réalisation de ce composant électronique peuvent comporter une ou plusieurs des caractéristiques des revendications dépendantes.

Ces modes de réalisation du composant électronique présentent en outre les avantages suivants :
- maximiser la surface de la couche d'interface thermique en recouvrant avec elle la surface extérieure de la couche épaisse permet d'accroître l'efficacité de l'évacuation de la chaleur vers l'extérieur du composant électronique et donc de refroidir la puce électronique ;
- lorsque le fond de la cavité débouche directement sur la face de la puce électronique, cela accroît l'efficacité du lissage de la température de cette puce électronique ;
- utiliser une couche de fermeture pour refermer la cavité réalisée dans un matériau présentant une bonne conductivité thermique permet d'améliorer l'évacuation de la chaleur de la puce électronique vers l'extérieur et donc d'améliorer son refroidissement. Cette couche est avantageusement rapportée.
- lorsque la couche de fermeture est en contact avec la couche d'interface thermique, l'évacuation de la chaleur est favorisée davantage ;
- utiliser en tant que matériau absorbeur de chaleur un matériau à changement de phase permet d'absorber la chaleur produite par la puce électronique tout en maintenant la température constante ;
- utiliser une couche épaisse dont le module de Young et strictement inférieur au module de Young de la puce électronique permet d'améliorer la résistance au choc mécanique du composant électronique.

L'invention a également pour objet un procédé de fabrication d'un composant électronique conforme à la revendication 10.

Les modes de réalisation de ce procédé de fabrication peuvent comporter une ou plusieurs des caractéristiques des revendications dépendantes de procédé.

Ces modes de réalisation du procédé présentent en outre l'avantage suivant :
- le moulage permet de réaliser en une seule opération le dépôt de la couche épaisse et la cavité.

L'invention sera mieux comprise à la lecture de la description qui va suivre, donnée uniquement à titre d'exemple non limitatif et faite en se référant aux dessins sur lesquels :
- la figure 1 est une illustration schématique en coupe verticale d'un composant électronique,
- les figures 2 et 3 sont des organigrammes de procédés respectifs de fabrication du composant électronique de la figure 1 ;
- les figures 4 et 5 sont des illustrations schématiques en coupe verticale de deux autres modes de réalisation d'un composant électronique.

Dans ces figures, les mêmes références sont utilisées pour désigner les mêmes éléments.

Dans la suite de cette description, les caractéristiques et les fonctions bien connues de l'homme du métier ne sont pas décrites en détail.

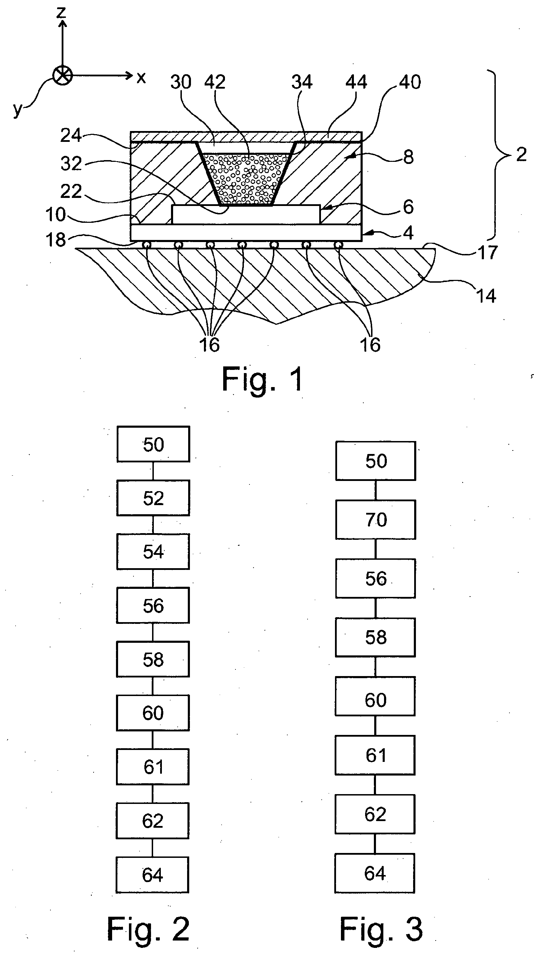

La figure 1 représente un composant électronique 2. Ce composant 2 comporte :
- un substrat 4,
- au moins une puce électronique 6 assemblée sur le substrat 4, et
- une couche épaisse 8 recouvrant une face supérieure 10 du substrat 4 et une partie de la puce électronique 6.

Le substrat 4 s'étend essentiellement horizontalement parallèlement à un plan appelé « plan du substrat ». Le plan du substrat est parallèle à des directions orthogonales X et Y. La direction verticale sur les figures est représentée par une direction Z perpendiculaire aux directions X et Y. Ici, les termes « dessus », « dessous », « supérieur » et « inférieur » sont définis par rapport à la direction Z.

Le substrat 4 permet de raccorder électriquement la puce 6 à un circuit électronique et, par exemple, un circuit imprimé 14, dont seule une partie est représentée sur ces figures. A cet effet, le substrat 4 comprend des connexions électriques 16, raccordant électriquement et mécaniquement ce substrat à des pistes électriques réalisées sur une face supérieure 17 du circuit imprimé 14. Ici, ces pistes électriques du circuit imprimé 14 n'ont pas été représentées.

Les connexions électriques 16 sont par exemple des billes fusibles situées sur une face inférieure 18 du substrat 4. La face inférieure 18 est située du côté opposé à la face 10. Ces billes fusibles sont soudées sur des pistes correspondantes du circuit imprimé 14. De telles connexions électriques sont également connues sous le terme de « micro-piliers ». Cet assemblage de billes est connu sous l'acronyme BGA (« Ball Grid Array »). Les billes 16 sont par exemple réalisées dans un métal conducteur tel que du cuivre, mélangé avec un matériau de fluage tel que de l'étain.

Le substrat 4 comporte également des pistes électriques raccordant des plots de connexion de la puce 6 à des connexions respectives 16 du substrat 4. Pour simplifier la figure 1, ces pistes électriques du substrat 4 n'ont pas été représentées.

Typiquement, le substrat 4 est réalisé dans un matériau dur dont la dureté est par exemple supérieure ou égale à celle du silicium. Ici, le substrat 4 est par exemple réalisé en silicium. L'épaisseur du substrat 4 est typiquement supérieure à 100 µm ou 300 µm.

La puce 6 comporte de nombreux composants électriques actifs ou passifs pour réaliser une fonction prédéterminée. Un composant électrique actif est défini comme étant un composant électronique qui permet d'augmenter la puissance d'un signal, par exemple la tension ou le courant ou les deux. La puissance supplémentaire est récupérée au travers d'une alimentation. Il s'agit typiquement de composants réalisés à partir de semi-conducteurs tels que des transistors ou des thyristors. A l'inverse, un composant électronique passif est défini comme ne permettant pas d'accroître la puissance d'un signal. Il s'agit typiquement d'une résistance, d'un condensateur, d'une inductance ou d'une bobine ou encore d'une diode ou de tout assemblage de ces composants. Ici, la puce 6 comprend par exemple des transistors MOS (« Metal Oxide Semiconductor »). La puce 6 est également connue sous le terme anglais de « die ». Elle inclut une face active à partir de laquelle ou dans laquelle sont réalisés les composants actifs ou passifs et une face 22 passivée. Par exemple, la face 22 est la face arrière de la puce. La face active est tournée vers la face supérieure 10. Elle est mécaniquement et électriquement raccordée à cette face supérieure 10 du substrat par des connexions électriques entre des plots de la puce 6 et de la face 10. Par exemple, ces connexions électriques sont également réalisées au moyen de microbilles fusibles ou micro-piliers formant un ensemble BGA.

La face 22 de la puce 6 est ici rendue électriquement isolante par dépôt d'une couche de passivation non représentée.

La couche épaisse 8 constitue l'essentielle du boîtier du composant 2. Elle permet de protéger la puce 6 et la face 10 du substrat contre des agressions mécaniques et chimiques provenant de l'environnement extérieur du composant 2. A cet effet, elle recouvre directement :
- la face 10 du substrat 4 qui n'est pas située sous la puce 6,
- les parois verticales de la puce 6, et
- dans ce mode de réalisation, une partie de la face 22 de la puce 6.

La couche 8 présente également une face extérieure 24 horizontale tournée du côté opposé au substrat 4.

Plus précisément, la couche 8 protège la puce 6 contre l'humidité et les chocs mécaniques. A cet effet, en ce qui concerne l'humidité, la couche 8 satisfait le test d'étanchéité appelé « chaleur humide ». Un tel test d'étanchéité est par exemple défini dans les normes GEDEC. Cette norme définit notamment le test suivant :
1) caractérisation du composant électronique sous condition standard,
2) placer le composant électronique des centaines d'heures, typiquement plus de 500 heures, à 85 °C avec une humidité de 85 %, ensuite
3) caractériser le fonctionnement du composant électronique sous condition standard.

Si les valeurs relevées lors des points 1) et 3) ci-dessus sont égales à une marge d'erreur prédéfinie par la norme GEDEC, alors la couche 8 est dite étanche.

Pour protéger la puce électronique contre les chocs, la couche épaisse est réalisée dans un matériau qui permet de répartir et d'abaisser les contraintes mécaniques entre la puce 6 et le substrat 4. Par exemple, à cet effet, le module de Young à 25 °C de la couche 8 est choisi strictement inférieur à celui de la puce 6. Par exemple, le module de Young de la puce 6 est sensiblement égal au module de Young du silicium. Le module de Young de la couche 8 est alors choisi généralement inférieur à 100 GPa ou à 20 GPa à 25 °C.

La couche 8 est aussi électriquement isolante pour isoler électriquement la puce 6 de l'environnement extérieur. Ici, on considère qu'une couche est électriquement isolante si sa conductivité à 25 °C est inférieure à 10⁻⁴ S/m et, de préférence, inférieure à 10⁻⁷ ou 10⁻¹⁰ S/m.

Pour atteindre ces résultats, généralement, la couche 8 comporte un certain volume de polymère qui varie de 5% à 100% du volume total de la couche 8. Le volume de polymère peut aussi être supérieur à 50 % du volume total. Typiquement, le polymère est uniformément réparti dans la couche 8. Il peut s'agir par exemple d'une résine époxy.

De plus, généralement, la couche 8 présente une faible conductivité thermique, c'est-à-dire une conductivité thermique à 25 °C inférieure à 50 W.m⁻¹.K⁻¹ et, typiquement, inférieure à 15 W.m⁻¹.K⁻¹.

Le boîtier du composant 2 comporte une ou plusieurs cavités réalisées dans couche 8 juste au-dessus de la puce 6. Pour simplifier la figure 1, seule une cavité 30 est représentée.

La cavité 30 comporte un fond horizontal 32 qui débouche directement sur la face 22 de puce 6, et une paroi latérale 34 qui s'étend depuis le fond 32 jusqu'à la face extérieure 24. Ici, la paroi latérale 34 est tronconique et s'évase progressivement et continûment en allant du fond 32 vers la face extérieure 24.

L'entrée de la cavité 30 débouche dans la face extérieure 24. La plus grande largeur de cette entrée est typiquement supérieure à 1 µm et peut atteindre jusqu'à 1 mm ou 2 mm ou 5 mm.

Le volume de la cavité 30 est supérieur à 1 nanolitre et, de préférence, supérieur à 10 ou 100 µl.

Le fond 32 et la paroi latérale 34 de la cavité 30 sont directement recouverts par une couche 40 d'interface thermique. Cette couche 40 permet d'améliorer le refroidissement de la puce 6. A cet effet, elle est réalisée dans un matériau bon conducteur thermique. Ici, par bon conducteur thermique, on désigne un matériau dont la conductivité thermique est supérieure à 10 W.m⁻¹.K⁻¹ et, de préférence, supérieure à 100 ou 200 ou 300 W.m⁻¹.K⁻¹ à 25°C. Par exemple, la couche 40 est réalisée dans un métal ou dans un matériau organique. Ici, la couche 40 est en cuivre ou en argent ou en aluminium

L'épaisseur de la couche 40 est typiquement supérieure à 10 nm et, de préférence, supérieure à 0,1 µm ou 50 µm ou plus.

Dans ce mode de réalisation, la couche 40 s'étend également sur toute la face extérieure 24.

La cavité 30 est essentiellement remplie d'un matériau 42 absorbeur de chaleur. A cet effet, la capacité thermique massique à 25 ° et sous une pression de 100 kPa du matériau 42 est supérieure à 1 kJ.Kg⁻¹.K⁻¹ et, de préférence, supérieure à 1,2 kJ.Kg⁻¹.K⁻¹.

Ici, le matériau 42 est un matériau à changement de phase dont la température de fusion pour passer de l'état solide à l'état liquide est située à l'intérieur d'une plage de températures normales d'utilisation du composant 2. Par exemple, la plage de températures d'utilisation du composant 2 est comprise entre -90 °C et 250 °C et, généralement, entre -25 °C et 200 °C. Ici, la température de fusion T_{f} du matériau 42 est choisie dans la plage [0 °C ; 200 °C] et, de préférence, dans la plage [100 °C ; 200 °C].

Le matériau 42 présente une chaleur latente de changement de phase importante, c'est-à-dire supérieure à 100 J/g et, de préférence, supérieure à 200 J/g. Cela permet au matériau 42 d'absorber une quantité importante de chaleur sans changer de température lorsque sa température de fusion est atteinte. La chaleur latente de changement de phase est également connue sous le terme d'Enthalpie de changement de phase ou d'état.

Par exemple, le matériau 42 est choisi dans les matériaux listés dans le tableau ci-dessous.

| **PCM** | **T (°C)** | **J/g** | **Densité (Kg/m³)** | **KJ/cm³** | **Chaleur spécifique J/g.K** | **ΔV (%)** | **Conductivité thermique (W/K.m)** | **Diffusivité (m²/s)** |
|---|---|---|---|---|---|---|---|---|
| Erythriol | 118 | 340 | 1480 | 0,5 | 1,38 | 13,8% | 2,64 | 1,29E-06 |
| PlusICE X180 | 180 | 301 | 1330 | 0,4 | 1,38 | 9,0% | 0,99 | 5,41 E-07 |
| A164 | 164 | 306 | 1500 | 0,5 | 1,38 | 10,0% | 0,20 | 9.66E-08 |
| H110 | 110 | 243 | 2145 | 0,5 | 2,41 | 10,0% | 0,45 | 8,70E-08 |

Dans le tableau ci-dessus :
- la première colonne contient le nom du matériau à changement de phase,
- la seconde colonne sa température du fusion,
- la troisième colonne sa chaleur latente de changement de phase,
- la quatrième sa densité,
- la cinquième sa capacité thermique volumique,
- la sixième sa capacité thermique à 25°C sous une pression de 100 kPa,
- la septième son augmentation de volume lors du passage de l'état solide à l'état liquide,
- la huitième sa conductivité thermique à 25°C, et
- la neuvième sa diffusivité.

Les matériaux PlusICE X180 et A164 et H110 sont les références commerciales de produits vendus par la société « PCM Products Ltd ».

Le volume du matériau 42 dans l'état solide est inférieur à son volume dans l'état liquide. Le volume du matériau 42 est choisi pour remplir plus de 90 % ou 95 % ou 99 % du volume de la cavité 30 dans l'état liquide. Par conséquent, le volume du matériau 42 dans l'état solide remplit en général moins de 90 % du volume total de la cavité 30. Sur la figure 1, le matériau 42 est représenté dans son état solide et un espace vide existe à l'intérieur de la cavité pour permettre la dilatation du matériau 42 lorsque celui-ci passe dans son état liquide.

Pour empêcher le matériau 42 de s'échapper en dehors de la cavité 30 quand il est dans son état liquide, une couche 44 de fermeture obstrue complètement l'entrée de la cavité 30. Cette couche 44 s'étend horizontalement pour recouvrir totalement l'entrée de la cavité 30 et toute la périphérie de cette cavité. Ici, la couche 44 recouvre toute la face extérieure 24. Elle est directement déposée sur la partie de la couche 40 qui s'étend horizontalement sur la face extérieure 24.

La couche 44 est réalisée dans un matériau bon conducteur thermique pour faciliter le refroidissement de la puce 6 et la dissipation de la chaleur vers l'extérieur. Par exemple, elle est réalisée dans un métal tel que le cuivre ou l'aluminium ou dans des matériaux tel que le graphène, le graphite ou des nanotubes de carbone. Son épaisseur est typiquement supérieure à 1 µm ou 10 µm et généralement inférieure à 1 ou 2 millimètres.

Le fonctionnement du composant 2 est le suivant. Quand la température de la puce 6 augmente, la chaleur est transmise au matériau 42 par l'intermédiaire de la couche 44. Le matériau 42 absorbe la chaleur et passe progressivement dans son état liquide. Cette absorption de chaleur s'effectue donc à température constante égale à la température de fusion du matériau 42. Dans le même temps, les couches 40 et 44 dissipent une partie de la chaleur produite par la puce 6 à l'extérieur du composant 2. Quand la température de la puce 6 diminue, le matériau 42 se solidifie. Il libère alors la chaleur qu'il avait emmagasinée pour passer dans son état liquide. La chaleur libérée est diffusée puis rayonnée vers l'extérieur du composant 2 par les couches 40 et 44. Ainsi, la présence du matériau 42 dans la couche épaisse 8 permet d'atténuer les pics transitoires de température de la puce 6.

La fabrication du composant 2 va maintenant être décrite à l'aide du procédé de la figure 2.

Lors d'une étape 50, le substrat 4 et la puce 6 assemblée sur la face 10 du substrat 4 sont fournis. Par exemple, la puce 6 est assemblée sur la face 10 par l'intermédiaire de billes fusibles. Ici, à ce stade, le substrat 4 a déjà été découpé de sorte que chaque substrat 4 comporte uniquement la ou les puces électroniques d'un seul composant électronique.

Plusieurs puces 6 et leurs substrats 4 respectifs sont alors placés les uns à côté des autres avec les faces arrières 22 exposées vers le haut.

Lors d'une étape 52, on procède au dépôt collectif de la couche épaisse 8 qui recouvre complètement la face 22 et les parties exposées à l'extérieur de la face supérieure 10 du substrat 4. En faisant cela, on reconstitue une plaque en polymère avec des puces 6 à l'intérieur. Cette plaque reconstituée est généralement ronde.

Lors d'une étape 54, la cavité 30 est réalisée au-dessus de chaque puce 6. Par exemple, la cavité 30 est réalisée à l'aide d'un masque formé sur la face extérieure 24 et délimitant l'emplacement de chaque cavité 30. Ensuite, la couche épaisse 8 est gravée uniquement aux emplacements ainsi délimités en utilisant la face 22 des puces 6 comme couche d'arrêt. Cela permet de mettre à nu une partie de la face 22 de chaque puce au fond de chaque cavité.

Lors d'une étape 56, la couche 40 d'interface thermique est déposée. Par exemple, pour cela, une couche mince en cuivre est déposée sur le fond 32, la paroi latérale 34 et sur la face extérieure horizontale 24. L'épaisseur de cette couche mince est supérieure à 10 nm ou 100 nm et généralement inférieure à 1 µm ou 5 µm. Ensuite, une couche additionnelle de cuivre ou d'un mélange d'autres métaux bons conducteurs thermiques est déposée sur cette couche mince par électrolyse pour former la couche 40 dont l'épaisseur est supérieure à 10 ou 50 µm.

Lors d'une étape 58, éventuellement, la couche 40 est structurée. Par exemple, la couche 40 est structurée pour libérer des lignes de coupe de la plaque reconstituée. Cette structuration de la couche 40 est par exemple réalisée par photolithographie et gravure ou par irradiation avec un laser sans photolithographie.

Lors d'une étape 60, la cavité 30 est remplie avec le matériau 42 dans l'état liquide. Par exemple, le matériau 42 est injecté à l'aide d'une seringue ou d'une buse chauffée à une température supérieure à sa température de fusion dans chacune des cavités 30.

Ensuite, lors d'une étape 61, le matériau 42 se refroidit en dessous de sa température de fusion et passe donc dans son état solide.

Lors d'une étape 62, chaque cavité 30 est fermée avec sa couche 44 de fermeture. Par exemple, chaque couche 44 de fermeture est fabriquée indépendamment de la plaque reconstituée. Ici, chaque couche 44 est une plaque carrée ou rectangulaire de plus de 100 µm de côté ou de plus de 1 millimètre de côté. Ensuite, la couche 44 est collée sur la face extérieure 24 pour obstruer complètement l'entrée de la cavité 30. Le collage de la couche 44 peut être réalisé grâce à une couche adhésive mince dont l'épaisseur est inférieure à 1 ou 5 µm. Le collage peut également être réalisé par collage direct, c'est-à-dire sans apport de matériau adhésif si, par exemple, les couches 40 et 44 sont toutes les deux en métal. Le collage direct est par exemple obtenu en comprimant la couche 44 contre la couche 40 et en chauffant à une température inférieure à la température de fusion du matériau 42.

Enfin, lors d'une étape 64, la plaque reconstituée est découpée de manière à séparer chacun des composants électroniques des autres composants électroniques simultanément fabriqués.

Le composant électronique 2 représenté sur la figure 1 est alors obtenu.

La figure 3 représente un autre procédé de fabrication du composant 2. Ce procédé de fabrication est identique à celui de la figure 2 sauf que les étapes 52 et 54 sont remplacées par une étape 70. L'étape 70 est une étape de moulage de la couche épaisse 8 sur la face supérieure 10 et sur les puces 6. Cette étape 70 est réalisée à l'aide d'un moule qui contient pour chaque cavité une forme en relief ou bosse dont la forme est complémentaire à la forme de la cavité. Ainsi, en déposant la couche 8 à l'aide de ce moule, on réalise en même temps le dépôt de la couche 8 et les cavités 30.

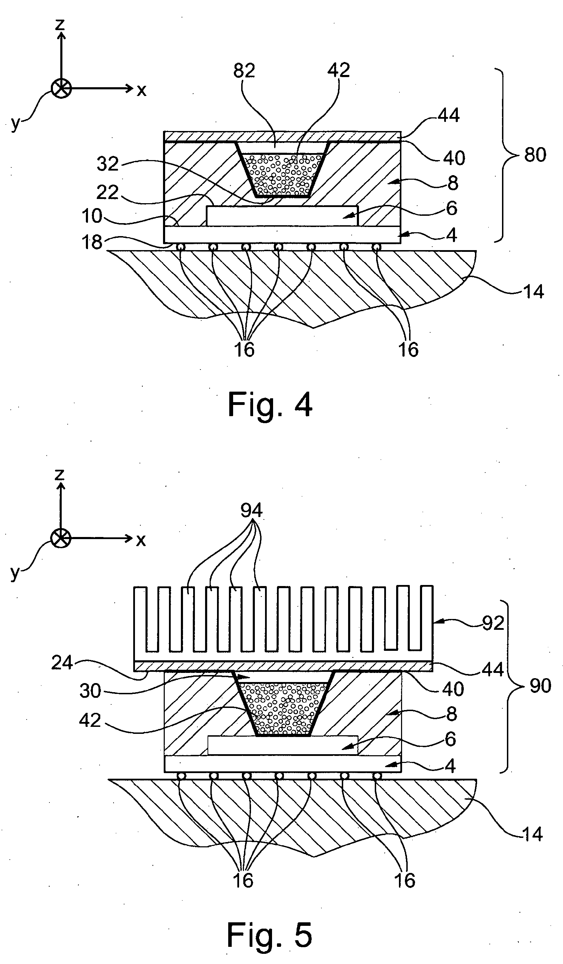

La figure 4 représente un composant électronique 80. Ce composant 80 est identique au composant 2, sauf que la cavité 30 est remplacée par une cavité 82. La cavité 82 est identique à la cavité 30 mais moins profonde. Ainsi, le fond 32 de la cavité 82 est séparé de la face de la puce 6 par une distance verticale d'au moins 1 µm et typiquement inférieure à 200 µm.

La figure 5 représente un composant électronique 90. Ce composant 90 est identique au composant 2, sauf qu'il comporte en plus un radiateur 92 équipé d'ailettes verticales 94. Ce radiateur 92 est attaché directement sur la couche 44 de fermeture. Ici, cette couche 44 s'étend horizontalement au-delà de la face extérieure 24 pour maximiser la surface de contact entre cette couche 44 et le radiateur 92. Par exemple, le radiateur 92 est réalisé dans un matériau bon conducteur thermique tel que l'aluminium. La présence du radiateur 92 facilite et accélère le refroidissement de la puce 6.

De nombreux autres modes de réalisation sont possibles. Par exemple, plusieurs cavités peuvent être situées au-dessus de la même face 22 de la même puce 6. En effet, pour des questions de résistance mécanique au choc, il peut être préférable de réaliser plusieurs petites cavités au-dessus de la puce 6 plutôt qu'une seule grande cavité.

A l'inverse, le fond d'une même cavité peut s'étendre au-dessus de plusieurs faces arrières de plusieurs puces électroniques disposées horizontalement les unes à côté des autres.

La couche 44 de fermeture peut être réalisée dans des métaux ou dans des matériaux organiques tels que du graphène, du graphite ou des nanotubes de carbone.

En variante, seule une partie de la paroi latérale 34 de la cavité est recouverte de la couche 40 d'interface thermique. Dans une autre variante, la couche d'interface thermique recouvre uniquement le fond de la cavité ou uniquement la paroi latérale 34.

Plusieurs puces électroniques peuvent être empilées verticalement les unes au-dessus des autres. Dans ce cas, la cavité débouche sur la face 22 de la puce électronique située la plus en haut dans l'empilement.

La puce 6 peut aussi être totalement ou en partie enterrée à l'intérieur du substrat. Par exemple, lorsqu'elle est totalement enterrée à l'intérieur du substrat, sa face 22 est au même niveau que la face 10 du substrat ou est enfouie à l'intérieur du substrat 4.

Les connexions électriques entre la puce 6 et le substrat ou entre le substrat 4 et le circuit imprimé 14 peuvent prendre d'autres formes. Par exemple, il peut s'agir de broches électriques.

Le fond 32 de la cavité peut s'étendre sur la totalité de la face de la puce 6. Dans ce cas, la couche 8 ne recouvre pas la face 22 mais uniquement les faces verticales de cette puce 6 et une partie de la face supérieure 10.

Dans un autre mode de réalisation, la face active de la puce 6 s'étend sur la totalité de la face supérieure 10 du substrat 4. Dans ce cas, la couche 8 ne recouvre pas directement la face supérieure 10 mais uniquement une partie de la face 22 de la puce 6.

Dans le mode de réalisation décrit ici, la face 22 a été décrite comme étant la face arrière de la puce. En variante, il peut s'agir d'une autre face, tel que la face avant, de la puce.

D'autres matériaux absorbeurs de température que des matériaux à changement de phase peuvent être utilisés. Par exemple, le matériau absorbeur de température peut être réalisé à l'aide d'un matériau qui peut passer de façon réversible entre plusieurs états solides différents. Par exemple, il s'agit d'un matériau élastocalorique ou d'un matériau à mémoire de forme qui présente à l'état solide deux états cristallographiques et qui peut passer de façon réversible de l'un à l'autre. L'un de ces états cristallographiques est généralement connu sous le terme de « phase martensitique » et un autre de ces états solides est connu sous le terme de « phase austénitique ».

D'autres modes de réalisation du procédé de fabrication sont possibles. Par exemple, lors de l'étape 50, il n'est pas nécessaire que le substrat ait déjà été découpé. Dans ce cas, le substrat 4 comporte des puces électroniques destinées à être intégrées dans plusieurs composants électroniques distincts. Généralement, dans ce cas, le substrat 4 prend la forme d'une plaquette circulaire. Par exemple, la découpe du substrat 4 pour séparer les différentes puces électroniques simultanément fabriquées a alors lieu lors de l'étape 64.

L'étape 54 peut aussi être réalisée en irradiant la face extérieure 24 de la couche 8 uniquement à l'emplacement où doit être creusée la cavité 30 avec un laser. Le laser fait fondre localement cette couche 8 pour creuser la cavité 30.

La couche 40 peut être déposée selon d'autres procédés. Par exemple, si la couche 40 est réalisée dans un matériau organique, ce dépôt organique est déposé en suspension dans une solution contenant un solvant volatile sur le fond 32, sur la paroi latérale 34 de la cavité et sur la face extérieure 24. Ensuite, le solvant volatile s'évapore et la couche en matériau organique se sédimente sur la couche 8. Le matériau organique est par exemple du graphène, du graphite ou des nanotubes de carbone. La couche 40 peut être également déposée par laminage.

Le remplissage de la cavité 30 avec le matériau 42 peut aussi être réalisé différemment. Par exemple, le matériau 42 est étendu sur la face extérieure 24 à l'état liquide. Ensuite, cette face extérieure 24 est raclée avec une lame pour éliminer le matériau 42 situé en dehors des cavités 30.

On peut également procéder de la même façon lorsque le matériau 42 présente une texture pâteuse.

Le collage de la couche 44 peut aussi être réalisé différemment. Par exemple, la couche 44 est collée sur la face extérieure de la couche 40 en utilisant des forces de Van Der Waals. Il est aussi possible, lors de l'étape 62, de déposer une couche 44, d'un seul bloc de matière, qui recouvre toutes les faces extérieures de la plaque reconstituée. Ensuite, cette couche 44 est découpée lors de l'étape 64.

## Revendications

1. Composant électronique comportant :
- un substrat (4) qui s'étend dans un plan appelé « plan du substrat », ce substrat étant équipé de connexions électriques pour raccorder le composant électronique à un circuit électronique, ce substrat présentant une face supérieure (10),
- au moins une puce électronique (6) disposée sur la face supérieure du substrat et/ou à l'intérieur du substrat et électriquement raccordée aux connexions électriques par l'intermédiaire de ce substrat,
- un boîtier formé par une couche épaisse (8) en matériau électriquement isolant recouvrant la face supérieure du substrat et/ou au moins une partie de la puce électronique, la couche épaisse (8) présentant une face extérieure (24) parallèle au plan du substrat,
- au moins une cavité (30 ; 82) réalisée à l'intérieur de la couche épaisse (8) et située au-dessus de la puce électronique (6) dans une direction perpendiculaire au plan du substrat, cette cavité (30 ; 82) présentant un fond (32) parallèle au plan du substrat et au moins une paroi latérale (34) s'éloignant à partir du fond jusqu'à la face extérieure de la couche épaisse, cette cavité étant en totalité ou en partie remplie par un matériau (42) absorbeur de chaleur, ce matériau absorbeur de chaleur étant différent du matériau formant la couche épaisse,
- une couche (40) d'interface thermique recouvrant au moins le fond de la cavité et/ou sa paroi latérale,
**caractérisé en ce que** :
- la capacité thermique massique du matériau (42) absorbeur de chaleur est supérieure à 1 kJ.Kg⁻¹.K⁻¹ à une température de 25 °C et à une pression de 100 kPa, et
- la couche (40) d'interface thermique est réalisée dans un matériau dont la conductivité thermique à 25 °C est supérieure à 100 W.m⁻¹.K-¹.

2. Le composant selon la revendication 1, dans lequel au moins le fond de la cavité et sa paroi latérale sont recouverts par la couche (40) d'interface thermique.

3. Le composant selon la revendication 2, dans lequel la couche (40) d'interface thermique recouvre également une partie de la face extérieure de la couche épaisse.

4. Le composant selon l'une quelconque des revendications précédentes, dans lequel la cavité (30) présente un fond (32) parallèle au plan du substrat et débouchant directement sur une face (22) de la puce électronique.

5. Le composant selon l'une quelconque des revendications précédentes, dans lequel le composant électronique comporte une couche (44) de fermeture disposée sur la face extérieure de la couche épaisse et obstruant complètement l'entrée de la cavité pour la fermer hermétiquement au matériau absorbeur de chaleur, cette couche de fermeture présentant une conductivité thermique à 25 °C supérieure à 100 W.m⁻¹.K⁻¹.

6. Le composant selon les revendications 3 et 5, dans lequel la couche (44) de fermeture est en contact direct avec au moins une partie de la couche (40) d'interface thermique.

7. Le composant selon l'une quelconque des revendications précédentes, dans lequel le matériau (42) absorbeur de chaleur est un matériau à changement de phase apte à absorber de la chaleur par passage de l'état solide à l'état liquide ou gazeux, sa chaleur latente de changement de phase étant supérieure à 100 J/g et la température de changement de phase du matériau à changement de phase étant comprise entre 0 et 200 °C.

8. Le composant selon l'une quelconque des revendications précédentes, dans lequel le module de Young de la couche épaisse (8) est strictement inférieur au module de Young de la puce électronique (6).

9. Le composant selon l'une quelconque des revendications précédentes, dans lequel la couche épaisse (8) est réalisée en polymère.

10. Procédé de fabrication d'un composant électronique, ce procédé comportant :
- la fourniture (50) d'un substrat qui s'étend dans un plan appelé « plan du substrat », ce substrat étant équipé de connexions électriques pour raccorder le composant électrique à un circuit électronique, le substrat présentant une face supérieure,
- la fourniture (50) d'au moins une puce électronique disposée sur la face supérieure du substrat et/ou à l'intérieur du substrat et électriquement raccordée aux connexions électriques par l'intermédiaire du substrat,
- le dépôt (52 ; 70) d'une couche épaisse en matériau électriquement isolant recouvrant la face supérieure du substrat et/ou au moins une partie de la puce électronique, la couche épaisse présentant une face extérieure parallèle au plan du substrat,
- la réalisation (54 ; 70) d'une cavité à l'intérieur de la couche épaisse, cette cavité étant située au-dessus de la puce électronique dans une direction perpendiculaire au plan du substrat, cette cavité présentant un fond parallèle au plan du substrat et au moins une paroi latérale s'éloignant à partir du fond jusqu'à la face extérieure de la couche épaisse,
- le dépôt (56) d'une couche d'interface thermique au moins sur le fond de la cavité et/ou sa paroi latérale,
- le remplissage (60) de tout ou partie de cette cavité avec un matériau absorbeur de chaleur, ce matériau absorbeur de chaleur étant différent du matériau formant la couche épaisse,
**caractérisé en ce que** :
- la capacité thermique massique du matériau absorbeur de chaleur est supérieure à 1 kJ.Kg⁻¹.K⁻¹ à une température de 25 °C et à une pression de 100 kPa, et
- la couche d'interface thermique est réalisée dans un matériau dont la conductivité thermique à 25 °C est supérieure à 100 W.m⁻¹.K⁻¹.

11. Procédé selon la revendication 10, dans lequel le dépôt (70) de la couche épaisse et la réalisation (70) de la cavité sont simultanément réalisés par dépôt du matériau formant la couche épaisse sur la face supérieure du substrat ou au moins sur une partie de la puce électronique à l'aide d'un moule contenant une empreinte en relief de la cavité.

12. Procédé selon la revendication 10, dans lequel la cavité est réalisée par gravure de la couche épaisse à travers un masque ou par irradiation à l'aide d'un laser de la couche épaisse de manière à provoquer la fusion de cette couche épaisse à l'emplacement de la cavité.

13. Procédé selon l'une quelconque des revendications 10 à 12, dans lequel le procédé comporte le dépôt (56) d'une couche d'interface thermique au moins sur le fond de la cavité et sa paroi latérale.

## Patentansprüche

1. Elektronisches Bauteil, umfassend:
- ein Substrat (4), das sich in einer Ebene, "Substratebene" genannt, erstreckt, wobei dieses Substrat mit elektrischen Anschlüssen ausgestattet ist, um das elektronische Bauteil an eine elektronische Schaltung anzuschließen, wobei dieses Substrat eine Oberseite (10) aufweist,
- mindestens einen elektronischen Chip (6), der auf der Oberseite des Substrats und/oder im Inneren des Substrats angeordnet und elektrisch mit den elektrischen Anschlüssen mit Hilfe dieses Substrats verbunden ist,
- ein Gehäuse, das von einer dicken Schicht (8) aus einem elektrisch isolierenden Material gebildet ist, die die Oberseite des Substrats und/oder zumindest einen Teil des elektronischen Chips bedeckt, wobei die dicke Schicht (8) eine Außenseite (24) parallel zur Ebene des Substrats aufweist,
- mindestens einen Hohlraum (30; 82), der im Inneren der dicken Schicht (8) hergestellt und über dem elektronischen Chip (6) in eine Richtung senkrecht auf die Ebene des Substrats angeordnet ist, wobei dieser Hohlraum (30; 82) einen Boden (32) parallel zur Ebene des Substrats und mindestens eine Seitenwand (34) aufweist, die sich vom Boden bis zur Außenseite der dicken Schicht entfernt, wobei dieser Hohlraum zur Gänze oder zum Teil mit einem Wärme absorbierenden Material (42) gefüllt ist, wobei sich dieses Wärme absorbierende Material von dem Material, das die dicke Schicht bildet, unterscheidet,
- eine thermische Schnittstellenschicht (40), die zumindest den Boden des Hohlraums und/oder seine Seitenwand bedeckt;
**dadurch gekennzeichnet, dass**:
- die wärmebezogene thermische Kapazität des Wärme absorbierenden Materials (42) größer als 1 kJ.Kg⁻¹.K⁻¹ bei einer Temperatur von 25 °C und einem Druck von 100 kPa ist, und
- die thermische Schnittstellenschicht (40) aus einem Material hergestellt ist, dessen Wärmeleitfähigkeit bei 25 °C über 100 W.m⁻¹.K⁻¹ beträgt.

2. Bauteil nach Anspruch 1, bei dem zumindest der Boden des Hohlraums und seine Seitenwand mit der thermischen Schnittstellenschicht (40) bedeckt sind.

3. Bauteil nach Anspruch 2, bei dem die thermische Schnittstellenschicht (40) auch einen Teil der Außenseite der dicken Schicht bedeckt.

4. Bauteil nach einem der vorhergehenden Ansprüche, bei dem der Hohlraum (30) einen Boden (32) parallel zur Ebene des Substrats aufweist, der direkt auf einer Seite (22) des elektronischen Chips mündet.

5. Bauteil nach einem der vorhergehenden Ansprüche, wobei das elektronische Bauteil eine Verschlussschicht (44) umfasst, die auf der Außenseite der dicken Schicht angeordnet ist und den Eingang des Hohlraums zur Gänze verschließt, um ihn gegen das Wärme absorbierende Material hermetisch dicht zu verschließen, wobei diese Verschlussschicht eine Wärmeleitfähigkeit bei 25 °C über 100 W.m⁻¹.K⁻¹ aufweist.

6. Bauteil nach den Ansprüchen 3 und 5, bei dem die Verschlussschicht (44) in direktem Kontakt mit mindestens einem Teil der thermischen Schnittstellenschicht (40) ist.

7. Bauteil nach einem der vorhergehenden Ansprüche, bei dem das Wärme absorbierende Material (42) ein Material mit Phasenänderung ist, das geeignet ist, die Wärme durch Übergang vom festen Zustand in den flüssigen oder gasförmigen Zustand zu absorbieren, wobei seine latente Phasenänderungswärme größer als 100 J/g ist, und die Phasenänderungstemperatur zwischen 0 und 200 °C beträgt.

8. Bauteil nach einem der vorhergehenden Ansprüche, bei dem das Young-Modul der dicken Schicht (8) unbedingt niedriger als das Young-Modul des elektronischen Chips (6) ist.

9. Bauteil nach einem der vorhergehenden Ansprüche, bei dem die Dicke Schicht (8) aus Polymer hergestellt ist.

10. Verfahren zur Herstellung eines elektronischen Bauteils, wobei dieses Verfahren umfasst:
- die Bereitstellung (50) eines Substrats, das sich in einer Ebene, "Substratebene" genannt, erstreckt, wobei dieses Substrat mit elektrischen Anschlüssen ausgestattet ist, um das elektronische Bauteil an eine elektronische Schaltung anzuschließen, wobei dieses Substrat eine Oberseite aufweist,
- die Bereitstellung (50) mindestens eines elektronischen Chips, der auf der Oberseite des Substrats und/oder im Inneren des Substrats angeordnet und elektrisch mit den elektrischen Anschlüssen mit Hilfe dieses Substrats verbunden ist,
- das Aufbringen (52; 70) einer dicken Schicht aus einem elektrisch isolierenden Material, die die Oberseite des Substrats und/oder zumindest einen Teil des elektronischen Chips bedeckt, wobei die dicke Schicht eine Außenseite parallel zur Ebene des Substrats aufweist,
- die Herstellung (54; 70) eines Hohlraums im Inneren der dicken Schicht, wobei dieser Hohlraum über dem elektronischen Chip in eine Richtung senkrecht auf die Ebene des Substrats angeordnet ist, wobei dieser Hohlraum einen Boden parallel zur Ebene des Substrats und mindestens eine Seitenwand aufweist, die sich vom Boden bis zur Außenseite der dicken Schicht entfernt,
- das Aufbringen (56) einer thermischen Schnittstellenschicht zumindest auf den Boden des Hohlraums und/oder seine Seitenwand,
- das Füllen (60) der Gesamtheit oder eines Teils dieses Hohlraums mit einem Wärme absorbierenden Material, wobei sich dieses Wärme absorbierende Material von dem die dicke Schicht bildenden Material unterscheidet,
**dadurch gekennzeichnet, dass**:
- die wärmebezogene thermische Kapazität des Wärme absorbierenden Materials größer als 1 kJ.Kg⁻¹.K⁻¹ bei einer Temperatur von 25 °C und einem Druck von 100 kPa ist, und
- die thermische Schnittstellenschicht aus einem Material hergestellt ist, dessen Wärmeleitfähigkeit bei 25 °C über 100 W.m⁻¹.K⁻¹ beträgt.

11. Verfahren nach Anspruch 10, bei dem das Aufbringen (70) der dicken Schicht und die Herstellung (70) des Hohlraums gleichzeitig durch Aufbringen des die dicke Schicht bildenden Materials auf die Oberseite des Substrats oder zumindest einen Teil des elektronischen Chips mit Hilfe einer Form, die einen reliefartigen Abdruck des Hohlraums enthält, durchgeführt werden.

12. Verfahren nach Anspruch 10, bei dem der Hohlraum durch Gravur der dicken Schicht durch eine Maske oder durch Bestrahlen der dicken Schicht mit Hilfe eines Lasers, um das Schmelzen dieser dicken Schicht an der Stelle des Hohlraums hervorzurufen, hergestellt wird.

13. Verfahren nach einem der Ansprüche 10 bis 12, wobei das Verfahren das Aufbringen (56) einer thermischen Schnittstellenschicht zumindest auf den Boden des Hohlraums und seine Seitenwand umfasst.

## Claims

1. Electronic component comprising :
- a substrate (4) that extends in a plane called the "substrate plane", this substrate being equipped with electrical connections to connect the electronic component to an electronic circuit, this substrate having an upper face (10),
- at least one electronic chip (6) arranged on the upper face of the substrate and/or inside the substrate and electrically connected to the electrical connections by way of this substrate,
- a package formed by a thick layer (8) of electrically insulating material covering the upper face of the substrate and/or at least part of the electronic chip, the thick layer (8) having an outer face (24) parallel to the substrate plane,
- at least one cavity (30; 82) produced inside the thick layer (8) and situated above the electronic chip (6) in a direction perpendicular to the substrate plane, this cavity (30; 82) having a bottom (32) parallel to the substrate plane and at least one side wall (34) extending from the bottom as far as the outer face of the thick layer, this cavity being totally or partly filled with a heat-absorbing material (42), this heat-absorbing material being different from the material forming the thick layer,
- a thermal interface layer (40) covering at least the bottom of the cavity and/or its side wall,
**characterized in that**:
- the specific heat capacity of the heat-absorbing material (42) is greater than 1 kJ.Kg⁻¹.K⁻¹ at a temperature of 25 °C and at a pressure of 100 kPa, and
- the thermal interface layer is made of a material having a thermal conductivity at 25 °C of greater than 100 W.m⁻¹.K⁻¹.

2. Component according to Claim 1, in which at least the bottom of the cavity and its side wall are covered by the thermal interface layer (40).

3. Component according to Claim 2, in which the thermal interface layer (40) also covers part of the outer face of the thick layer.

4. Component according to any one of the preceding claims, in which the cavity (30) has a bottom (32) parallel to the substrate plane and opening directly onto a face (22) of the electronic chip.

5. Component according to any one of the preceding claims, in which the electronic component has a seal coat (44) arranged on the outer face of the thick layer and completely obstructing the cavity entrance to hermetically seal it to the heat-absorbing material, this seal coat having a thermal conductivity at 25 °C of greater than 100 W.m⁻¹.K⁻¹.

6. Component according to Claims 3 and 5, in which the seal coat (44) makes direct contact with at least part of the thermal interface layer (40).

7. Component according to any one of the preceding claims, in which the heat-absorbing material (42) is a phase-change material capable of absorbing heat by passing from the solid state to the liquid or gaseous state, its latent phase change heat being greater than 100 J/g and the temperature of the phase change of the phase-change material being comprised between 0 and 200 °C.

8. Component according to any one of the preceding claims, in which the Young modulus of the thick layer (8) is strictly below the Young modulus of the electronic chip (6).

9. Component according to any one of the preceding claims, in which the thick layer (8) is made of polymer.

10. Process for fabricating an electronic component, this process comprising:
- providing (50) a substrate that extends in a plane called the "substrate plane", this substrate being equipped with electrical connections to connect the electronic component to an electronic circuit, the substrate having an upper face,
- providing (50) at least one electronic chip arranged on the upper face of the substrate and/or inside the substrate and electrically connected to the electrical connections by way of the substrate,
- depositing (52 ; 70) a thick layer made of electrically insulating material covering the upper face of the substrate and/or at least part of the electronic chip, the thick layer having an outer face parallel to the substrate plane,
- producing (54 ; 70) a cavity inside the thick layer, this cavity being situated above the electronic chip in a direction perpendicular to the substrate plane, this cavity having a bottom parallel to the substrate plane and at least one side wall extending from the bottom as far as the outer face of the thick layer,
- depositing (56) a thermal interface layer at least on the bottom of the cavity and/or on its side wall,
- filling (60) all or part of this cavity with a heat-absorbing material, this heat-absorbing material being different from the material forming the thick layer,
**characterized in that**:
- the specific heat capacity of the heat-absorbing material is greater than 1 kJ.Kg⁻¹.K⁻¹ at a temperature of 25 °C and at a pressure of 100 kPa, and
- the thermal interface layer is made from a material having a thermal conductivity at 25 °C of greater than 100 W.m⁻¹.K⁻¹.

11. Process according to Claim 10, in which the deposition (70) of the thick layer and the production (70) of the cavity are performed simultaneously by depositing the material forming the thick layer on the upper face of the substrate or at least on part of the electronic chip using a mould containing a relief imprint of the cavity.

12. Process according to Claim 10, in which the cavity is produced by etching the thick layer through a mask or by irradiating the thick layer using a laser so as to cause this thick layer to melt in the location of the cavity.

13. Process according to any one of Claims 10 to 12, in which the process comprises depositing (56) a thermal interface layer at least on the bottom of the cavity and on its side wall.
